(19) Europäisches Patentamt
European Patent Office
Office européen des brevets

(11) **EP 3 815 117 B1**

(12) **FASCICULE DE BREVET EUROPEEN**

(45) Date de publication et mention de la délivrance du brevet:
**03.12.2025 Bulletin 2025/49**

(21) Numéro de dépôt: **19733780.1**

(22) Date de dépôt: **26.06.2019**

(51) Classification Internationale des Brevets (IPC):
**H01F 27/28** (2006.01)     **G01R 15/18** (2006.01)
**H01F 38/30** (2006.01)     H01F 27/255 (2006.01)
**H01F 38/32** (2006.01)

(52) Classification Coopérative des Brevets (CPC):
**H01F 27/2804; G01R 15/185; H01F 38/30;**
H01F 27/255; H01F 38/32; H01F 2027/2809

(86) Numéro de dépôt international:
**PCT/EP2019/067081**

(87) Numéro de publication internationale:
**WO 2020/002475 (02.01.2020 Gazette 2020/01)**

(54) **TRANSFORMATEUR DE MESURE COMPORTANT UN CIRCUIT IMPRIME**

MESSWANDLER MIT EINER LEITERPLATTE

MEASUREMENT TRANSFORMER INCLUDING A PRINTED CIRCUIT BOARD

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **27.06.2018 FR 1855758**

(43) Date de publication de la demande:
**05.05.2021 Bulletin 2021/18**

(73) Titulaire: **Safran Electronics & Defense 75015 Paris (FR)**

(72) Inventeurs:
• **CHETANNEAU, Patrice 75015 Paris (FR)**
• **GUILLOT, François 75015 Paris (FR)**

(74) Mandataire: **Cabinet Boettcher 5, rue de Vienne 75008 Paris (FR)**

(56) Documents cités:
**EP-A1- 1 884 783**     **CN-A- 105 632 893**
**CN-B- 105 632 893**     **DE-A1- 102016 119 164**
**JP-A- 2015 070 367**     **US-A1- 2017 222 563**

**EP 3 815 117 B1**

## Description

L'invention concerne le domaine des transformateurs de mesure comportant un circuit imprimé.

ARRIERE PLAN DE L'INVENTION

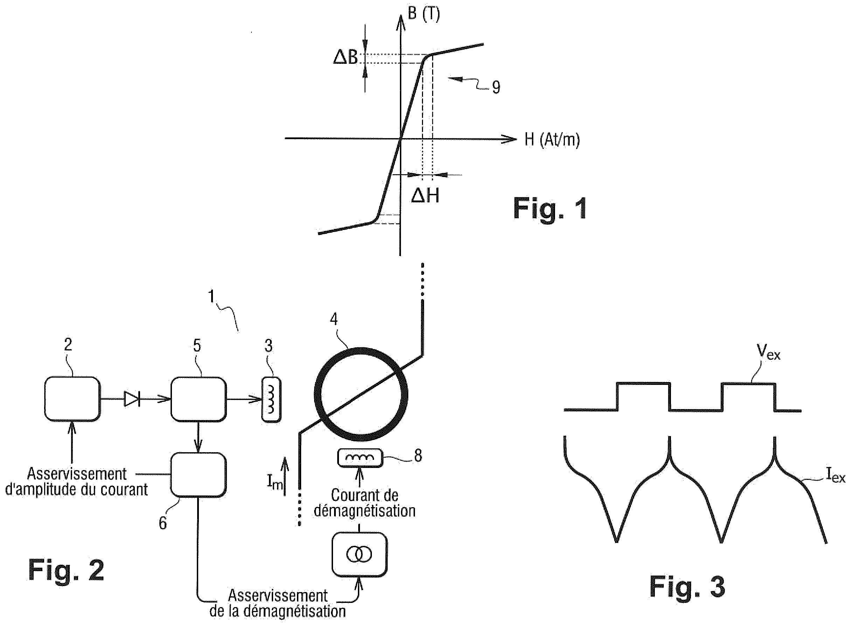

Un capteur de courant à vanne de flux utilise la propriété d'un matériau magnétique formant un noyau magnétique de se saturer à partir d'un certain niveau d'excitation magnétique. En référence à la figure 1, pour un champ magnétique H croissant, la pente de la fonction de transfert entre le champ magnétique H et l'induction magnétique B diminue grandement à partir d'une valeur dite de saturation du noyau magnétique. La valeur de saturation, sur la figure 1, correspond aux intervalles $\Delta H$ et $\Delta B$.

En référence aux figures 2 et 3, dans un capteur de courant à vanne de flux classique 1 destiné à mesurer un courant Im circulant sur un conducteur, un générateur de signaux rectangulaires 2 applique une tension d'excitation rectangulaire Vex aux bornes d'un enroulement d'excitation 3 enroulé autour d'un noyau magnétique 4. Le courant d'excitation Iex circulant dans l'enroulement d'excitation 3 est mesuré par un module de mesure 5. Un détecteur de crêtes 6, relié au module de mesure 5, fournit deux informations : le niveau de saturation et la différence des courants de crête du courant d'excitation Iex. Le niveau de saturation permet d'asservir l'amplitude de la tension d'excitation Vex. La différence des courants de crête du courant d'excitation Iex permet d'estimer le courant à mesurer Im et d'asservir, via un convertisseur de tension en courant 7, l'amplitude d'un courant de démagnétisation qui circule dans un enroulement de démagnétisation 8 et qui permet de compenser le flux magnétique produit dans le noyau magnétique 4 par le courant à mesurer Im.

Les capteurs de courant à vanne de flux sont privilégiés dans un certain nombre d'applications. C'est notamment le cas pour la mesure d'un courant circulant dans un organe de coupure de type SSPC (pour « Solid State Power Controller ») à destination d'un équipement utilisateur, ou bien pour la mesure d'un courant circulant dans un organe de conversion d'énergie de type PEM (pour « Power Electronic Module ») relié à une phase d'un moteur.

Le document EP1884783A1 divulgue un dispositif de mesure de courant comprenant un capteur de courant comportant : - un circuit magnétique, - une pluralité de bobinages dont au moins un bobinage d'excitation chargé de l'excitation du circuit magnétique, - au moins un bobinage de détection, le capteur étant doté de bobinages formant un transformateur dont au moins un bobinage primaire en regard du circuit magnétique par lequel un courant I à mesurer est destiné à entrer, et au moins un bobinage secondaire en regard du circuit magnétique susceptible de produire un champ magnétique de contre réaction. Le courant I à mesurer est destiné à être divisé entre les branches conductrices du bobinage primaire.

OBJET DE L'INVENTION

L'invention a pour objet d'améliorer la reproductibilité industrielle et de réduire le coût d'un capteur de courant à vanne de flux.

RESUME DE L'INVENTION

En vue de la réalisation de ce but, on propose un transformateur de mesure selon la revendication 1 comportant un circuit imprimé et un noyau magnétique, le circuit imprimé comprenant une couche isolante, un ensemble traversant primaire comprenant des premiers trous métallisés primaires et des deuxièmes trous métallisés primaires s'étendant au travers de la couche isolante, l'ensemble traversant primaire formant une portion d'un enroulement primaire du transformateur de mesure, ledit enroulement primaire comprenant une unique spire, le circuit imprimé comportant en outre un ensemble traversant secondaire comprenant des premiers trous métallisés secondaires et des deuxièmes trous métallisés secondaires s'étendant au travers de la couche isolante, l'ensemble traversant secondaire formant une portion d'un enroulement secondaire du transformateur de mesure, ledit enroulement secondaire comprenant plusieurs spires reliées en série, le noyau magnétique s'étendant dans une épaisseur du circuit imprimé.

Les caractéristiques électriques des trous métallisés primaires et des trous métallisés secondaires du circuit imprimé sont parfaitement reproductibles. Par ailleurs, en intégrant le noyau magnétique du transformateur de mesure selon l'invention dans une épaisseur du circuit imprimé, on maîtrise parfaitement le matériau utilisé pour sa fabrication, sa structure et donc ses caractéristiques.

De plus, le transformateur de mesure selon l'invention est peu coûteux, puisqu'il est formé d'un circuit imprimé, de trous métallisés et d'un noyau magnétique directement intégré au circuit imprimé.

Ainsi, en intégrant le transformateur de mesure selon l'invention dans un capteur de courant à vanne de flux, on améliore la reproductibilité industrielle et on réduit le coût dudit capteur de courant à vanne de flux.

L'invention sera mieux comprise à la lumière de la description qui suit d'un mode de mise en œuvre particulier non limitatif de l'invention.

BREVE DESCRIPTION DES DESSINS

Il sera fait référence aux dessins annexés, parmi lesquels :

- la figure 1 représente la courbe d'une fonction de transfert entre un champ magnétique et une induction magnétique ;
- la figure 2 représente un capteur de courant à vanne de flux existant ;
- la figure 3 représente la courbe d'une tension d'excitation et la courbe d'un courant d'excitation qui excitent un noyau magnétique du capteur de courant à vanne de flux existant ;
- la figure 4 représente un nouveau capteur de courant à vanne de flux comprenant un transformateur selon l'invention ;
- la figure 5 représente un pont diviseur de courant intégré dans un circuit imprimé et utilisé pour mesurer un courant à mesurer ;
- la figure 6 est une vue en coupe du transformateur selon l'invention utilisé dans le nouveau capteur de courant à vanne de flux ;
- la figure 7 est une vue analogue à celle de la figure 6, mais de dessus.

DESCRIPTION DETAILLEE DE L'INVENTION

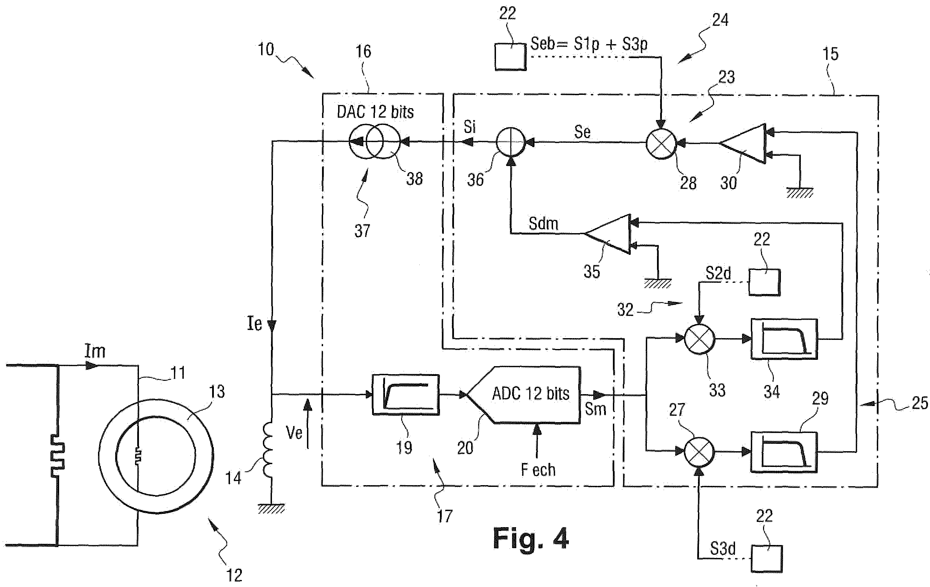

En référence à la figure 4, un capteur de courant à vanne de flux 10 est ici utilisé pour mesurer un courant à mesurer Im qui circule sur un conducteur 11.
Le capteur de courant à vanne de flux 10 comporte un transformateur de mesure selon l'invention 12 comprenant un noyau magnétique 13, un enroulement primaire et un enroulement secondaire. L'enroulement primaire est le conducteur 11. Le noyau magnétique 13 s'étend autour du conducteur 11. L'enroulement secondaire est un enroulement de mesure 14 enroulé autour du noyau magnétique 13.
Le capteur de courant à vanne de flux 10 comporte une pluralité de composants électroniques formant une partie numérique 15 et une partie analogique 16.
La partie numérique 15 comporte un composant de traitement numérique qui est en l'occurrence un FPGA mais qui pourrait être un composant différent : microcontrôleur, processeur, ASIC, etc.
Le capteur de courant à vanne de flux 10 comprend de plus un circuit d'acquisition 17. Le circuit d'acquisition 17 appartient à la partie analogique 16.
Le circuit d'acquisition 17 est relié à l'enroulement de mesure 14.
Le circuit d'acquisition 17 comprend un filtre passe-haut 19 et un convertisseur analogique numérique 20 connecté à une sortie du filtre passe-haut 19.
Le convertisseur analogique numérique 20 est ici un convertisseur 12 bits dont le fonctionnement est cadencé à une fréquence Fech. Ici Fech = 100MHz. Le convertisseur analogique numérique 20 pourrait bien sûr présenter des caractéristiques différences.
Le circuit d'acquisition 17 acquiert une tension de mesure analogique Ve aux bornes de l'enroulement de mesure 14. La tension de mesure Ve est appliquée en entrée du filtre passe-haut 19.
La tension résultante est appliquée en entrée du convertisseur analogique numérique 20 qui produit un signal de mesure numérique Sm.
Le capteur de courant à vanne de flux 10 comprend un générateur haute fréquence 22. Le générateur haute fréquence 22 est intégré dans le FPGA (on pourrait remplacer le terme « intégré » par l'un des termes suivants : programmé, implémenté, mis en œuvre, etc.)
Le générateur haute fréquence 22 produit un signal de référence numérique de fréquence f0, un signal de référence numérique de fréquence 2.f0 et un signal de référence numérique de fréquence 3.f0.
Le signal de référence numérique de fréquence f0 est ici de la forme :

$$\texttt{S1r} = \sin(\omega 0 t).$$

Le signal de référence numérique de fréquence 2.f0 est ici de la forme :

$$\texttt{S2r} = \cos(2.\omega 0 t).$$

Le signal de référence numérique de fréquence 3.f0 est ici de la forme :

$$S3r = \sin(3.\omega 0t).$$

Le capteur de courant à vanne de flux 10 comprend de plus un circuit d'excitation 23. Le circuit d'excitation 23 est implémenté dans le FPGA.

Le circuit d'excitation 23 est relié au générateur haute fréquence 22.

Le circuit d'excitation 23 comporte un circuit d'excitation brute 24 et un circuit d'asservissement d'excitation 25.

Le circuit d'excitation brute 24 reçoit le signal de référence numérique de fréquence f0 et le signal de référence numérique de fréquence 3.f0 et produit à partir de ces signaux un signal d'excitation partiel numérique de fréquence f0 et un signal d'excitation partiel numérique de fréquence 3.f0.

Le signal d'excitation partiel numérique de fréquence f0 est ici de la forme :

$$S1p = k1.\sin(\omega 0t).$$

Le signal d'excitation partiel numérique de fréquence 3.f0 est ici de la forme :

$$S3p = k2.\sin(3.\omega 0t).$$

Le circuit d'excitation brute 24 additionne le signal d'excitation partiel numérique de fréquence f0 et le signal d'excitation partiel numérique de fréquence 3.f0 pour générer un signal d'excitation numérique brut. Le signal d'excitation nunérique brut est de la forme :

$$Seb = S1p + S3p = k1.\sin(\omega 0t) + k2.\sin(3\omega 0t).$$

Le circuit d'asservissement d'excitation 25 est relié au générateur haute fréquence 22.

Le circuit d'asservissement d'excitation 25 reçoit le signal de référence numérique de fréquence 3.f0 et produit à partir du signal de référence numérique de fréquence 3.f0 un signal de démodulation numérique de fréquence 3.f0.

Le signal de démodulation numérique de fréquence 3.f0 est ici de la forme :

$$S3d = k3.\sin(3.\omega 0t).$$

Le circuit d'asservissement d'excitation 25 comporte un premier multiplieur 27, un deuxième multiplieur 28, un intégrateur 29 et un premier amplificateur 30. Le premier amplificateur 30 est connecté à une sortie de l'intégrateur 29.

Le premier multiplieur 27 multiplie le signal de mesure numérique Sm par le signal de démodulation numérique de fréquence 3.f0. Le signal résultant est appliqué en entrée de l'intégrateur 29.

On note que le premier multiplieur 27 et l'intégrateur 29 jouent le rôle d'un premier démodulateur synchrone.

Le premier amplificateur 30 produit alors un signal d'erreur numérique. Le deuxième multiplieur 28 multiplie le signal d'excitation numérique brut Seb par le signal d'erreur numérique pour obtenir un signal d'excitation numérique. Le signal d'excitation numérique est de la forme :

$$Se = k0.(k1.\sin(\omega 0t) + k2.\sin(3\omega 0t)).$$

Le capteur de courant à vanne de flux 10 comprend de plus un circuit d'asservissement de démagnétisation 32. Le circuit d'asservissement de démagnétisation 32 est intégré dans le FPGA.

Le circuit d'asservissement de démagnétisation 32 est relié au générateur haute fréquence 22.

Le circuit d'asservissement de démagnétisation 32 reçoit le signal de référence numérique de fréquence 2.f0 et produit à partir du signal de référence numérique de fréquence 2.f0 un signal de démodulation numérique de fréquence 2.f0.

Le signal de démodulation numérique de fréquence 2.f0 est ici de la forme :

$$S2d = k4.\cos(2.\omega 0t).$$

Le circuit d'asservissement de démagnétisation 32 comporte un troisième multiplieur 33, un filtre passe-bas 34 et un deuxième amplificateur 35. Le deuxième amplificateur 35 est connecté à une sortie du filtre passe-bas 34.

Le troisième multiplieur 33 multiplie le signal de mesure numérique Sm par le signal de démodulation numérique de fréquence 2.f0. Le signal résultant est appliqué en entrée du filtre passe-bas 34. Le deuxième amplificateur 35 produit alors un signal image numérique du courant à mesurer Im, qui est aussi un signal de démagnétisation numérique Sdm. Le signal image numérique, ou signal de démagnétisation numérique Sdm, est de la forme Sdm = k.Im.

On note que le troisième multiplieur 33 et le filtre passe-bas 34 jouent le rôle d'un deuxième démodulateur synchrone.

Le capteur de courant à vanne de flux 10 comprend de plus un sommateur 36. Le sommateur 36 est implémenté dans le FPGA.

Le sommateur 36 somme le signal d'excitation numérique Se et le signal de démagnétisation numérique Sdm pour obtenir un signal d'injection numérique Si.

On a :

$$\texttt{Si = k0.(k1.sin(}\omega\texttt{0t) + k2.sin(3}\omega\texttt{0t)) + kIm.}$$

Le capteur de courant à vanne de flux 10 comporte en outre un circuit d'injection 37. Le circuit d'injection 37 appartient à la partie analogique 16.

Le circuit d'injection 37 est relié au sommateur 36 et à l'enroulement de mesure 14.

Le circuit d'injection 37 comprend un convertisseur numérique analogique 38.

Le convertisseur numérique analogique 38 est ici un convertisseur 12 bits dont le fonctionnement est cadencé à la fréquence Fech (Fech = 100MHz). Le convertisseur numérique analogique 38 pourrait bien sûr présenter des caractéristiques différentes.

Le convertisseur numérique analogique 38 acquiert le signal d'injection numérique Si, produit un courant d'excitation analogique Ie à partir du signal d'injection numérique Si, et injecte le courant d'excitation Ie dans l'enroulement de mesure 14.

On décrit maintenant le fonctionnement du capteur de courant à vanne de flux 10.

Le circuit d'excitation 23 génère un signal d'excitation numérique Se, qui est transformé en un courant d'excitation Ie et injecté dans l'enroulement de mesure 14.

La tension de mesure Ve est acquise puis numérisée pour produire un signal de mesure numérique Sm.

En sortie du deuxième amplificateur 35, on obtient un signal image numérique du courant à mesurer Im. Ce signal image numérique est utilisé pour estimer le courant à mesurer Im.

Le signal image numérique est aussi un signal de démagnétisation numérique Sdm qui permet de compenser le flux magnétique produit par le courant à mesurer Im.

Grâce au sommateur 36 et par mise en parallèle, on additionne facilement le signal de démagnétisation numérique Sdm et le signal d'excitation numérique Se. Le courant d'excitation Ie permet donc à la fois d'exciter le noyau magnétique 13 et de démagnétiser le noyau magnétique 13. Le courant de démagnétisation est donc intégré dans le courant d'excitation Ie.

La saturation du noyau magnétique 13 provoque une dissymétrie de la tension de mesure Ve, ladite tension de mesure Ve étant constituée par la somme d'une composante de fréquence f0 en sin($\omega$0t), correspondant à la fondamentale, et d'une composante de fréquence 2.f0 en cos(2$\omega$0t), correspondant à la composante harmonique d'ordre 2.

On note que l'amplitude du signal d'excitation partiel numérique de fréquence f0 et celle du signal d'excitation partiel numérique de fréquence 3.f0 sont réglées pour obtenir un courant d'excitation Ie dont la composante de fréquence 3.f0 (ou composante harmonique d'ordre 3) est en phase avec la composante de fréquence f0 (ou fondamentale).

La composante harmonique d'ordre 3 de la tension de mesure Ve, obtenue après démodulation synchrone via le premier démodulateur synchrone, est positive. En cas de saturation du noyau magnétique 13, la composante harmonique d'ordre 3 est atténuée plus fortement que la fondamentale et la composante harmonique d'ordre 3 après démodulation synchrone devient négative, car l'harmonique d'ordre 3 passe en opposition de phase avec la fondamentale.

Ainsi, lorsque le courant d'excitation Ie est tel que le noyau magnétique 13 se rapproche de la saturation, le rapport de l'amplitude de la composante harmonique d'ordre 1 et de l'amplitude de la composante harmonique d'ordre 3 de la tension de mesure Ve évolue jusqu'à annulation de la composante harmonique d'ordre 3, puis jusqu'à inversion de phase de la composante harmonique d'ordre 3. Le point de fonctionnement correspondant à l'annulation de la composante harmonique d'ordre 3 de la tension de mesure Ve est donc un point de fonctionnement optimal du capteur de courant à vanne de flux 10. Ce point de fonctionnement optimal correspond au coude 9 de la courbe de fonction de transfert de la figure 1.

En sortie du premier amplificateur 30, on obtient un signal d'erreur numérique.

Le signal d'erreur numérique permet d'asservir le courant d'excitation Ie. L'asservissement consiste à contrôler le courant d'excitation Ie pour annuler la composante harmonique d'ordre 3 de la tension de mesure Ve. Le capteur de courant à vanne de flux 10 fonctionne ainsi en permanence sur le point de fonctionnement optimal. On obtient de la sorte un gain maximal des dissymétries introduites par le courant à mesurer Im et détectables sur la tension de mesure Ve. On note que cet asservissement par démodulation synchrone de la composante harmonique d'ordre 3 est peu sensible aux perturbations électromagnétiques externes, car tous les signaux de fréquence différente de la fréquence 3.f0 génèrent des produits d'intermodulation dont les composantes sont filtrées par le filtre passe-bas 34 connecté en sortie du troisième multiplieur 33. On note par ailleurs que cet asservissement n'a pas besoin d'être très rapide, car les variations provenant de paramètres extérieurs (température, vieillissement) sont relativement lentes.

Ainsi, l'enroulement de mesure 14 est utilisé à la fois pour exciter le noyau magnétique 13, pour contrôler cette excitation, pour mesurer le courant à mesurer Im, et pour compenser le flux magnétique produit dans le noyau magnétique 13 par le courant à mesurer Im (démagnétisation).

La mutualisation de ces fonctions sur un seul enroulement de mesure 14 permet de simplifier, de réduire le coût et la masse, et de faciliter la fabrication du capteur de courant à vanne de flux 10.

On note par ailleurs que la chaîne de traitement de la mesure est principalement numérique : un unique FPGA permet de mettre en œuvre une grande partie de cette chaîne de traitement.

La numérisation de la chaîne de traitement augmente la fiabilité et la robustesse de celle-ci (notamment en température), réduit son coût, facilite sa fabrication et améliore sa reproductibilité industrielle.

L'amélioration de la régulation du point de fonctionnement grâce à la démodulation par le premier démodulateur synchrone permet par ailleurs d'obtenir une meilleure immunité aux bruits.

De plus, l'utilisation des démodulateurs synchrones permet de fonctionner à haute fréquence, ce qui autorise une bande passante importante du courant à mesurer Im tout en conservant une très bonne immunité aux perturbations électromagnétiques externes.

Comme la mesure se fait toujours dans le point de fonctionnement optimal correspondant au coude 9 de saturation, la sensibilité du capteur de courant à vanne de flux 10 est constante dans la plage de température. La précision du capteur de courant à vanne de flux 10 est donc bonne dans une plage importante de température.

Comme on l'a indiqué plus tôt, le capteur de courant à vanne de flux 10 mesure un courant à mesurer Im qui circule sur un conducteur 11.

Cette situation ne soulève pas de difficulté particulière lorsque le courant à mesurer Im est faible (inférieur à 1A par exemple).

Cependant, lorsque le courant à mesurer est important, une difficulté majeure se présente.

Le courant de démagnétisation, qui permet de compenser le flux magnétique produit dans le noyau magnétique 13 par le courant à mesurer Im, doit être lui aussi très important. La valeur du courant de démagnétisation doit être égale à celle du courant à mesurer divisé par le rapport de transformation du transformateur de mesure 12, associé aux caractéristiques de l'enroulement primaire et de l'enroulement secondaire.

Or, le nombre de spires de l'enroulement de mesure 14 est limité par son encombrement et par l'inductance résultante. Plus l'inductance est élevée, plus la vitesse de changement du courant de démagnétisation (issue du signal de démagnétisation numérique Sdm) sera limitée, et donc plus la bande passante du capteur de courant à vanne de flux 10 sera limitée. Ainsi, augmenter le nombre de spires de l'enroulement secondaire n'est pas une solution efficace.

Augmenter le courant de démagnétisation n'est pas non plus une solution efficace. En effet, cela implique de générer une tension de démagnétisation très importante sous un courant de démagnétisation important, ce qui est complexe à réaliser avec des composants standards.

On note que ce problème n'est pas propre au capteur de courant à vanne de flux 10 qui vient d'être décrit, mais concerne tout les capteurs de courant à vanne de flux (et notamment ceux qui comportent un enroulement dédié à la démagnétisation).

Pour résoudre cette difficulté, on met en œuvre un pont diviseur de courant de manière à réduire la valeur du courant à mesurer.

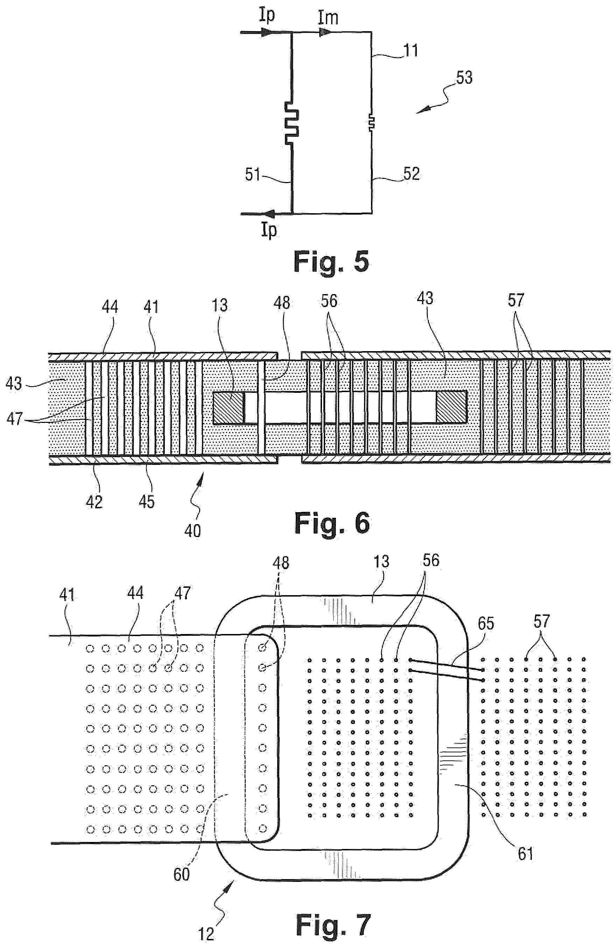

En référence aux figures 5 à 7, le capteur de courant à vanne de flux 10 comprend un circuit imprimé 40 sur lequel sont notamment montés la pluralité de composants électroniques formant la partie numérique 15 et la partie analogique 16.

Le circuit imprimé 40 comprend ici une première couche conductrice 41, une deuxième couche conductrice 42 et une couche isolante 43. La première couche conductrice 41 et la deuxième couche conductrice 42 s'étendent ici chacune sur une face opposée du circuit imprimé 40.

La première couche conductrice 41 comprend une première piste 44 et la deuxième couche conductrice 42 comprend une deuxième piste 45. La couche isolante 43 s'étend donc entre la première piste 44 et la deuxième piste 45.

Le circuit imprimé 40 comporte de plus un premier ensemble traversant d'au moins un premier trou métallisé primaire 47 et un deuxième ensemble traversant d'au moins un deuxième trou métallisé primaire 48. Ici, en l'occurrence, le premier ensemble traversant comprend plusieurs premiers trous métallisés primaires 47 et le deuxième ensemble traversant comprend plusieurs deuxièmes trous métallisés primaires 48. Les premiers trous métallisés primaires 47 et les deuxièmes trous métallisés primaires 48 ont ici tous un même premier diamètre.

Un « trou métallisé » pourrait aussi être appelé un « via ». Le « trou métallisé » peut être réalisé par tout type de procédé. Le « trou métallisé » peut en particulier être rendu conducteur par dépôt d'un matériau métallique ou de tout type de matériau conducteur. Le « trou métallisé » peut aussi être rendu conducteur par insertion d'un tube ou d'un rivet métallique, ou de tout type de conducteur.

Chaque premier trou métallisé primaire 47 et chaque deuxième trou métallisé primaire 48 relient la première piste 44 et la deuxième piste 45 en s'étendant au travers de la couche isolante 43. Chaque premier trou métallisé primaire 47 comprend ainsi une première extrémité reliée à la première piste 44 et une deuxième extrémité reliée à la deuxième piste 45. De même, chaque deuxième trou métallisé primaire 48 comprend ainsi une première extrémité reliée à la première piste et une deuxième extrémité reliée à la deuxième piste 45.

Le premier ensemble traversant, c'est-à-dire les premiers trous métallisés primaires 47, et le deuxième ensemble traversant, c'est-à-dire les deuxièmes trous métallisés primaires 48, forment respectivement une première branche 51 et une deuxième branche 52 d'un pont diviseur de courant 53.

Ainsi, le courant à mesurer Im est en réalité ici non pas un courant principal Ip dont on veut connaître la valeur, mais le courant à mesurer Im est issu d'une division du courant principal Ip et est utilisé pour estimer la valeur du courant principal Ip. Le courant principal Ip circule dans la première piste 44, dans la première branche 51 et la deuxième branche 52 du pont diviseur de courant 53, et dans la deuxième piste 45.

On voit bien ici que le conducteur 11 évoqué plus haut, sur lequel circule le courant à mesurer, est le deuxième ensemble traversant (ou la deuxième branche 52).

Ici, le courant principal Ip est égal à 10A.

Le nombre de premiers trous métallisés primaires 47 du premier ensemble traversant est neuf fois plus important que celui de deuxièmes trous métallisés primaires 48 du deuxième ensemble traversant. La deuxième résistance de la deuxième branche 52 est donc neuf fois plus élevée que la première résistance de la première branche 51.

Le courant à mesurer Im, circulant dans la deuxième branche 52 du pont diviseur de courant 53, est égal à 1A, alors que le courant circulant dans la première branche 51 du pont diviseur de courant 53 est égal à 9A.

On met ici à profit les propriétés de reproductibilité des caractéristiques électriques de plusieurs trous métallisés de même diamètre et adjacents sur le même circuit imprimé 40.

La première résistance de la première branche 51 et la deuxième résistance de la deuxième branche 52 sont mal connues mais leur rapport, lui, est connu de manière très précise grâce à cette reproductibilité.

Le premier ensemble traversant et le deuxième ensemble traversant sont donc équivalents à deux résistances *shunt* de rapport parfaitement maîtrisé.

On connaît donc de manière très précise le rapport entre le courant à mesurer Im et le courant principal Ip. Mesurer le courant à mesurer Im permet d'estimer très précisément le courant principal Ip, tout en réduisant celui-ci pour réduire le courant de démagnétisation requis.

Le courant à mesurer Im est mesuré grâce au transformateur de mesure selon l'invention 12 que l'on décrit désormais plus en détail.

Le transformateur de mesure selon l'invention 12 comporte le circuit imprimé 40 ou, plus exactement, une portion du circuit imprimé 40, car le circuit imprimé porte aussi la partie numérique 15 et la partie analogique 16.

Le premier ensemble traversant et le deuxième ensemble traversant qui viennent d'être décrits forment un « ensemble traversant primaire ». L'ensemble traversant primaires comprend donc les premiers trous métallisés primaires 47 et les deuxièmes trous métallisés primaires 48.Le circuit imprimé 40 comporte de plus un troisième ensemble traversant comportant au moins un premier trou métallisé secondaire 56 s'étendant au travers de la couche isolante 43, et un quatrième ensemble traversant comportant au moins un deuxième trou métallisé secondaire 57 s'étendant au travers de la couche isolante 43. Ici, en l'occurrence, le troisième ensemble traversant comprend plusieurs premiers trous métallisés secondaires 56 et le quatrième ensemble traversant comprend plusieurs deuxièmes trous métallisés secondaires 57. Les premiers trous métallisés secondaires 56 et les deuxièmes trous métallisés secondaires 57 ont ici tous un même deuxième diamètre qui, pour une raison d'encombrement, est inférieur au premier diamètre des premiers trous métallisés primaires 47 et des deuxièmes trous métallisés primaires 48. Le nombre de premiers trous métallisés secondaires 56 est égal au nombre de deuxièmes trous métallisés secondaires 57.

Le troisième ensemble traversant et le quatrième ensemble traversant forment un ensemble appelé ici « ensemble traversant secondaire ».

Le transformateur de mesure 12 comporte de plus le noyau magnétique 13. Le noyau magnétique 13 s'étend dans une épaisseur du circuit imprimé 40.

Le noyau magnétique 13 présente la forme d'un tube de sections extérieure et intérieure rectangulaires. Le noyau magnétique 13 comporte une portion de noyau primaire 60 et une portion de noyau secondaire 61.

Les premiers trous métallisés primaires 47 s'étendent à l'extérieur du noyau magnétique 13, à proximité de la portion de noyau primaire 60. Les deuxièmes trous métallisés primaires 48 s'étendent à l'intérieur du noyau magnétique 13, à proximité de la portion de noyau primaire 60.

L'ensemble traversant primaire forme ainsi une portion d'un enroulement primaire du transformateur de mesure 12, ledit enroulement primaire comportant ici une seule spire.

Les premiers trous métallisés secondaires 56 s'étendent à l'intérieur du noyau magnétique 13, à proximité de la portion de noyau secondaire 61. Les deuxièmes trous métallisés secondaires 57 s'étendent à l'extérieur du noyau magnétique 13, à proximité de la portion de noyau secondaire 61.

On voit que les premiers trous métallisés secondaires 56 et les deuxièmes trous métallisés secondaires 57 sont reliés entre eux par des éléments conducteurs 65 (par exemple, mais pas nécessairement, des pistes) qui s'étendent sur la première couche conductrice 41 et sur la deuxième couche conductrice 42. Seuls deux éléments conducteurs 65 sont représentés sur la figure 7.

Le troisième ensemble traversant forme ainsi une première portion de l'enroulement secondaire du transformateur de mesure 12. Le quatrième ensemble traversant forme ainsi une deuxième portion de l'enroulement secondaire du transformateur de mesure 12. L'ensemble traversant secondaire forme donc une portion de l'enroulement secondaire du transformateur de mesure 12.

L'enroulement secondaire comporte une pluralité de spires reliées en série, chaque spire comprenant un premier trou métallisé secondaire 56, un deuxième trou métallisé secondaire 57 et un élément conducteur 65.

Comme on l'aura compris, l'enroulement secondaire du transformateur de mesure 12 est l'enroulement de mesure 14 évoqué plus tôt.

Le transformateur de mesure 12 selon l'invention est très avantageux.

Les flux produits par les courants circulant dans les premiers trous métallisés primaires 47 et dans les deuxièmes trous métallisés primaires 48 sont opposés.

La différence de flux produite par le différentiel de nombre de trous métallisés génère le flux résultant effectivement reçu par le noyau magnétique 13. C'est ce flux résultant qui est utilisé pour la mesure du courant à mesurer Im. Le courant à mesurer Im est précisément à l'image du rapport entre le nombre de premiers trous métallisés primaires 47 et de deuxièmes trous métallisés primaires 48, ce qui permet de réaliser à très faible coût un diviseur de courant précis.

Ainsi, à l'opposé d'un transformateur « classique » de l'art antérieur, qui est conçu pour transporter le plus d'énergie possible via un volume et une masse les plus faibles possibles, le transformateur de mesure 12 permet d'obtenir une saturation pour un très faible champ magnétique. Dans ces conditions, la taille du noyau magnétique 13 peut être réduite, d'autant plus que le flux dans le noyau est minimisé par un flux de démagnétisation opposé à celui généré par le courant à mesurer Im.

On décrit maintenant la fabrication du circuit imprimé 40 et du noyau magnétique 13 qui s'étend dans une épaisseur du circuit imprimé 40.

Le circuit imprimé 40 comprend une première couche de « prépreg » (pour « préimprégné ») et une deuxième couche de « prépreg ». La première couche de prépreg et la deuxième couche de prépreg ne sont pas polymérisées.

Le noyau magnétique 13 comporte un mélange d'une poudre magnétique et d'une résine constituant un liant de la poudre magnétique.

La poudre magnétique est formée d'une structure cristalline, en l'occurrence de grenat d'yttrium et de fer ($Y_3Fe_{15}O_{12}$).

La résine est une résine époxy.

Le noyau magnétique 13 est déposé sur la première couche de prépreg par sérigraphie.

Puis, le noyau magnétique 13 est recouvert par la deuxième couche de prépreg.

Le circuit imprimé 40 est ensuite passé dans un four.

On perce alors le circuit imprimé 40 pour réaliser les trous métallisés qui ont été décrits.

Alternativement, il est possible fabriquer le noyau magnétique 13 en utilisant une technologie de fabrication additive par frittage laser.

La poudre magnétique est déposée sur une première couche de prépreg. Puis, un faisceau laser est utilisé pour agglomérer la couche de poudre magnétique sur des zones prédéfinies de manière à former le noyau magnétique 13.

Le noyau magnétique 13 est alors recouvert par la deuxième couche couche de prépreg.

La fabrication du noyau magnétique 13 par frittage laser semble plus efficace. En effet, dans le cas de la fabrication par sérigraphie, on constate que, dans le mélange de poudre magnétique et de résine, on trouve autant d'entrefers que de particules de poudre magnétique. Ces entrefers diminuent les performances du noyau magnétique 13. Dans le cas du frittage laser, les particules de la poudre magnétique sont fusionnées, ce qui évite de créer lesdits entrefers.

Bien entendu, l'invention n'est pas limitée au mode de réalisation décrit mais englobe toute variante entrant dans le champ de l'invention telle que définie par les revendications.

On a indiqué que le capteur de courant à vanne de flux comporte une partie numérique et une partie analogique, et que le convertisseur analogique numérique et le convertisseur numérique analogique appartiennent à la partie analogique. Bien sûr, on pourrait considérer que ces composants sont des composants numériques, et même qu'ils sont directement intégrés dans le FPGA (ou dans un microcontrôleur ou autre composant numérique), de sorte qu'ils appartiendraient alors à la partie numérique.

On a indiqué ici que la première couche conductrice comprenant la première piste et la deuxième couche conductrice comprenant la deuxième piste s'étendent ici chacune sur une face opposée du circuit imprimé. Bien sûr, la première couche conductrice et la deuxième couche conductrice pourraient être des couches internes du circuit imprimé, séparées par une ou plusieurs couches isolantes.

On a aussi décrit des ensembles traversant comprenant chacun un ou des trous métallisés. Les trous métallisés traversent ici une même couche isolante. Bien sûr, les trous métallisés pourraient traverser plusieurs couches isolantes, voir même une ou des couches isolantes et une ou des couches conductrices. Des ensembles traversant distincts pourraient aussi traverser des piles de couches distinctes.

Bien sûr, le transformateur selon l'invention peut être utilisé dans tout type d'application requérant un transformateur : l'invention n'est aucunement limitée aux capteurs de courant à vanne de flux.

## Revendications

1. Transformateur de mesure comportant un circuit imprimé (40) et un noyau magnétique (13) s'étendant dans une épaisseur du circuit imprimé, le noyau magnétique (13) présente la forme d'un tube de sections extérieure et intérieure rectangulaires, le circuit imprimé comprenant une couche isolante (43), un ensemble traversant primaire comprenant des premiers trous métallisés primaires (47) et des deuxièmes trous métallisés primaires (48) s'étendant au travers de la couche isolante (43), les premiers trous métallisés primaires (47) s'étendant à l'extérieur du noyau à proximité d'une portion de noyau primaire (60) et les deuxièmes trous métallisés primaires (48) s'étendant à l'intérieur du noyau à proximité de la portion de noyau primaire (60),

   chacun des premiers trous métallisés primaires (47) et des deuxièmes trous métallisés primaires (48) comprend une première extrémité reliée à une même première piste (44) d'une première couche conductrice (41) du circuit imprimé et une deuxième extrémité reliée à une même deuxième piste (45) d'une deuxième couche conductrice (42) du circuit imprimé,
   l'ensemble traversant primaire et les deux pistes (42, 44) formant un enroulement primaire comprenant une unique spire,
   le circuit imprimé comportant en outre un ensemble traversant secondaire comprenant des premiers trous métallisés secondaires (56) et des deuxièmes trous métallisés secondaires (57) s'étendant au travers de la couche isolante (43), l'ensemble traversant secondaire formant une portion d'un enroulement secondaire du transformateur de mesure, ledit enroulement secondaire comprenant plusieurs spires reliées en série, les premiers trous métallisés secondaires (56) s'étendant à l'intérieur du noyau à proximité d'une portion de noyau secondaire et les deuxièmes trous métallisés secondaires (57) s'étendant à l'extérieur du noyau à proximité de la portion de noyau secondaire (61).

2. Transformateur de mesure selon la revendication 1, dans lequel les premiers trous métallisés primaires (47) et les deuxièmes trous métallisés primaires (48) forment respectivement une première branche (51) et une deuxième branche (52) d'un pont diviseur de courant (53), le transformateur de mesure étant agencé pour mesurer un courant à mesurer (Im) circulant dans la deuxième branche (52) et issu d'une division d'un courant principal (Ip) circulant dans la première branche (51).

3. Transformateur de mesure selon l'une des revendications précédentes, dans lequel le noyau magnétique (13) est réalisé à partir notamment d'une poudre magnétique.

4. Transformateur de mesure selon la revendication 3, le noyau magnétique comportant un mélange d'une résine et de la poudre magnétique et étant déposé par sérigraphie sur une couche du circuit imprimé.

5. Transformateur de mesure selon la revendication 3, le noyau magnétique étant formé par frittage laser de la poudre magnétique déposée sur une couche du circuit imprimé (40).

6. Transformateur de mesure selon l'une des revendications 3 à 5, dans lequel la poudre magnétique comporte du grenat d'yttrium et de fer.

## Patentansprüche

1. Messwandler mit einer Leiterplatte (40) und mit einem sich in einer Dicke der Leiterplatte erstreckenden Magnetkern (13), wobei der Magnetkern (13) die Form eines Rohrs mit rechteckigem Außen- und Innenquerschnitt aufweist, wobei die Leiterplatte umfasst: eine Isolierschicht (43), eine primäre Durchgangsanordnung umfassend erste primäre metallisierte Löcher (47) und zweite primäre metallisierte Löcher (48), die sich durch die Isolierschicht (43) hindurch erstrecken, wobei sich die ersten primären metallisierten Löcher (47) außerhalb des Kerns in der Nähe eines primären Kernabschnitts (60) erstrecken und sich die zweiten primären metallisierten Löcher (48) innerhalb des Kerns in der Nähe des primären Kernabschnitts (60) erstrecken,

wobei ein jedes der ersten primären metallisierten Löcher (47) und der zweiten primären metallisierten Löcher (48) umfasst: ein erstes Ende, das mit ein und derselben ersten Bahn (44) einer ersten leitenden Schicht (41) der Leiterplatte verbunden ist, und ein zweites Ende, das mit ein und derselben zweiten Bahn (45) einer zweiten leitenden Schicht (42) der Leiterplatte verbunden ist,

wobei die primäre Durchgangsanordnung und die beiden Bahnen (42, 44) eine Primärwicklung mit einer einzigen Windung bilden,

wobei die Leiterplatte ferner eine sekundäre Durchgangsanordnung mit ersten sekundären metallisierten Löchern (56) und zweiten sekundären metallisierten Löchern (57) enthält, die sich durch die Isolierschicht (43) hindurch erstrecken, wobei die sekundäre Durchgangsanordnung einen Abschnitt einer Sekundärwicklung des Messwandlers bildet, wobei die Sekundärwicklung mehrere in Reihe verbundene Windungen umfasst, wobei sich die ersten sekundären metallisierten Löcher (56) innerhalb des Kerns in der Nähe eines sekundären Kernabschnitts erstrecken und sich die zweiten sekundären metallisierten Löcher (57) außerhalb des Kerns in der Nähe des sekundären Kernabschnitts (61) erstrecken.

2. Messwandler nach Anspruch 1, wobei die ersten primären metallisierten Löcher (47) und die zweiten primären metallisierten Löcher (48) jeweils einen ersten Zweig (51) und einen zweiten Zweig (52) einer Stromteilerbrücke (53) bilden, wobei der Messwandler zum Messen eines zu messenden Stroms (Im) ausgelegt ist, der in dem zweiten Zweig (52) fließt und durch eine Teilung eines in dem ersten Zweig (51) fließenden Hauptstroms (Ip) entsteht.

3. Messwandler nach einem der vorhergehenden Ansprüche, wobei der Magnetkern (13) insbesondere aus einem Magnetpulver hergestellt ist.

4. Messwandler nach Anspruch 3, wobei der Magnetkern eine Mischung aus einem Harz und Magnetpulver enthält und durch Siebdruck auf eine Schicht der Leiterplatte aufgebracht ist.

5. Messwandler nach Anspruch 3, wobei der Magnetkern durch Lasersintern des auf einer Schicht der Leiterplatte (40) aufgebrachten Magnetpulvers ausgebildet ist.

6. Messwandler nach einem der Ansprüche 3 bis 5, wobei das Magnetpulver Yttrium-Eisen-Granat enthält.


## Claims

1. A measurement transformer comprising a printed circuit (40) and a magnetic core (13) extending in a thickness of the printed circuit, the magnetic core (13) being in the shape of a tube having inside and outside sections that are rectangular, the printed circuit including an insulating layer (43), a primary through assembly comprising first primary plated through holes (47) and second primary plated through holes (48) extending through the insulating layer (43),

the first primary plated through holes (47) extending outside the core in the proximity of the primary core portion (60) and the second primary plated through holes (48) extending inside the core in the proximity of the primary core portion (60),

each of the first and second primary plated through holes (47, 48) has a first end connected to a common first track (44) of a first conductive layer (41) of the printed circuit and a second end connected to a common second track (45) of a second conductive layer (42) of the printed circuit,

the primary through assembly and the two tracks (42, 44) forming a primary winding having a single turn,

the printed circuit further including a secondary through assembly comprising first secondary plated through holes (56) and second secondary plated through holes (57) extending through the insulating layer (43), the secondary through assembly forming a portion of a secondary winding of the measurement transformer, said secondary winding comprising a plurality of turns connected in series, the first secondary plated through holes (56) extending inside the core in the proximity of a secondary core portion and the second secondary plated through holes (57) extending outside the core in the proximity of the secondary core portion (61).

2. A measurement transformer according to claim 1, wherein the first primary plated through holes (47) and the second primary plated through holes (48) form respectively a first branch (51) and a second branch (52) of a current divider bridge (53), the measurement transformer being arranged to measure a current (Im) that is to be measured flowing in the second branch (52) and obtained by dividing a main current (Ip) flowing in the first branch (51).

3. A measurement transformer according to any preceding claim, wherein the magnetic core (13) comprises a magnetic powder.

4. A measurement transformer according to claim 3, the magnetic core comprising a mixture of the magnetic powder and of a resin and being deposited on a layer of the printed circuit by silkscreen printing.

5. A measurement transformer according to claim 3, the magnetic core being made by laser sintering magnetic powder deposited on a layer of the printed circuit (40).

6. A measurement transformer according to one of claims 3 to 5, wherein the magnetic powder comprises yttrium iron garnet.

Fig. 3

Fig. 1

Fig. 2

**Fig. 4**

$Seb= S1p + S3p$

DAC 12 bits

ADC 12 bits

Ip    Im

11

53

51    52

Ip

## Fig. 5

44  41    13    48    56    43    57

43

47

42    45

40

## Fig. 6

48    13    56

41    44    47

65    57

60

61

12

## Fig. 7

## RÉFÉRENCES CITÉES DANS LA DESCRIPTION

**Documents brevets cités dans la description**

- EP 1884783 A1